Europäisches Patentamt

European Patent Office

Office européen des brevets

(11) Veröffentlichungsnummer: **0 300 184 B1**

# EUROPÄISCHE PATENTSCHRIFT

(45) Veröffentlichungstag der Patentschrift: **26.08.92**

(51) Int. Cl.5: **G11C 8/00**

(21) Anmeldenummer: **88109217.5**

(22) Anmeldetag: **09.06.88**

(54) **Schaltungsanordnung in einer integrierten Halbleiterschaltung.**

(30) Priorität: **10.06.87 DE 3719359**

(43) Veröffentlichungstag der Anmeldung:
**25.01.89 Patentblatt 89/04**

(45) Bekanntmachung des Hinweises auf die
Patenterteilung:
**26.08.92 Patentblatt 92/35**

(84) Benannte Vertragsstaaten:
**AT DE FR GB IT NL**

(56) Entgegenhaltungen:
**EP-A- 0 199 176**
**WO-A-85/05202**
**US-A- 4 027 174**

(73) Patentinhaber: **SIEMENS AKTIENGESELL-
SCHAFT**
**Wittelsbacherplatz 2**
**W-8000 München 2(DE)**

(72) Erfinder: **Fuchs, Hans Peter, Dipl.-Phys.**
**Mitterhoferstrasse 19**
**W-8000 München 21(DE)**

**Beschreibung**

Die Erfindung betrifft eine Schaltungsanordnung in einer integrierten Halbleiterschaltung nach dem Oberbegriff des Patentanspruches 1.

Gattungsgemäße Schaltungsanordnungen sind beispielsweise in integrierten Halbleiterspeichern, insbesondere in DRAM's eingesetzt. Der Einsatz kann beispielsweise als Wortleitungsdekoder-Treiberschaltung erfolgen. Eine ausgewählte Wortleitung soll dabei häufig einen höheren HIGH-Pegel aufweisen als die zugehörige Versorgungsspannung ("Wortleitungsüberhöhung"). Eine solche Wortleitungsüberhöhung ermöglicht beispielsweise das Einschreiben der Information "log. 1" in eine Speicherzelle mit ihrem vollen 1-Pegel. Auch beim Auslesen von Informationen aus Speicherzellen wirkt sich eine Wortleitungsüberhöhung positiv auf das entstehende Lesesignal aus. Die Überhöhung beträgt mindestens den Wert der Einsatzspannung der Auswahltransistoren der Speicherzellen. Meist beträgt die Überhöhung die Hälfte des Versorgungspotentials VDD.

Eine gattungsgemäße Schaltungsanordnung, aufgebaut in CMOS-Technik, ist beispielsweise aus der EP-A 0 199 176 bekannt.

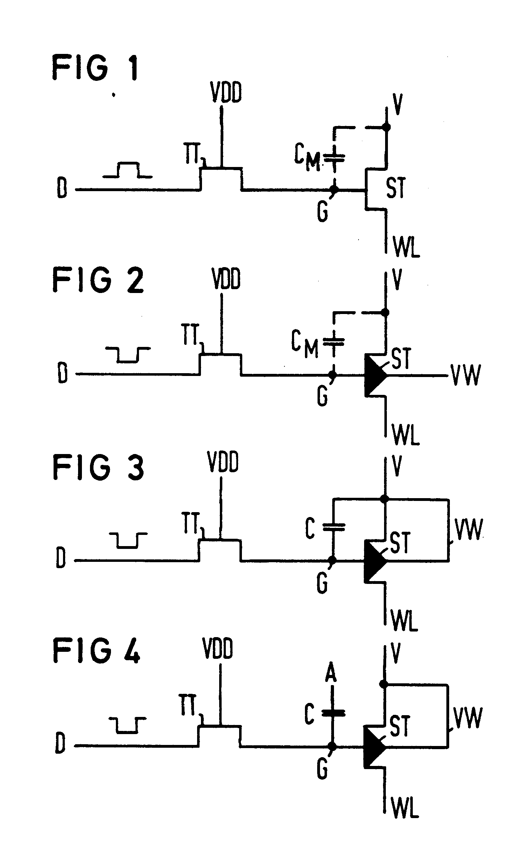

Figur 1 des vorliegenden Schutzrechtes stellt ebenfalls eine Schaltung nach dem Stand der Technik dar: An einem Transfertransistor TT liegt als Eingangssignal D beispielsweise das Ausgangssignal eines (nicht dargestellten) Adreßdekoders. Es weist im nicht-ausgewählten Zustand im allgemeinen das Bezugspotential VSS auf und im ausgewählten Zustand das Versorgungspotential VDD. Über den Transfertransistor TT, der gatemäßig mit dem Versorgungspotential VDD verbunden ist, ist das Eingangssignal D an das Gate eines Schalttransistors ST gelegt. Der Schalttransistor ST ist drainmäßig mit einem Wortleitungs-Spannungsgenerator verbunden. Dieser liefert eine getaktete Spannung V, deren beide Pegel einerseits dem Bezugspotential VSS der gesamten Schaltungsanordnung und andererseits der gegenüber dem Versorgungspotential VDD überhöhten Spannung Vx (z.B. 7,5 V) entsprechen. Die Source des Schalttransistors ST ist beispielsweise mit einer (im ausgewählten Zustand mit der getakteten Spannung V zu beaufschlagenden) Wortleitung WL verbunden. Der Betrieb der Schaltungsanordnung ist einfach: Im nicht-ausgewählten Zustand weist das Ausgangssignal der Dekoderschaltung den Pegel log. 0 auf (entspricht im wesentlichen dem Bezugspotential VSS). Dieses wird über den Transfertransistor TT an das Gate des Schalttransistors ST durchgeschaltet. Der Schalttransistor ST sperrt, wodurch die Wortleitung WL ebenfalls den Wert log. 0 annimmt (beispielsweise durch einen nicht dargestellten hochohmigen Widerstand zum Bezugspotential VSS).

Im ausgewählten Zustand jedoch (dies ist der elektrisch kritische Zustand) weist das Gate des Schalttransistors ST zunächst den Pegel log. 1 (entspricht im wesentlichen dem Versorgungspotential VDD) auf. Anschließend nimmt die an der Drain des Schalttransistors ST anliegende getaktete Spannung den überhöhten Wert Vx an.

Jeder Transistor weist, wie dem Fachmann geläufig, sogenannte parasitäre Kapazitäten auf. Entsprechend weist der Schalttransistor ST zwischen Drain und Gate eine solche parasitäre Kapazität $C_M$ auf (in Fig. 1 gestrichelt gezeichnet). Sie wird im allgemeinen als Miller-Kapazität bezeichnet. Über diese parasitäre Kapazität $C_M$ wird das am Gate des Schalttransistors ST anliegende Potential zu dem Zeitpunkt, zu dem die getaktete Spannung V ihren überhöhten Wert Vx annimmt, ebenfalls auf einen gegenüber der Versorgungsspannung VDD überhöhten Wert hochgepumpt ("geboostet"; der Transfertransistor TT sperrt gegenüber diesem überhöhten Wert). Der so entstehende überhöhte Spannungswert am Gate (meist gleich dem doppelten Wert von VDD) ermöglicht, daß an der Source des Schalttransistors ST als Ausgang der gesamten Schaltungsanordnung ebenfalls eine überhöhte Spannung auftritt, die wertemäßig in etwa gleich der überhöhten Spannung Vx ist. Sie stellt die Spannung dar, mit der eine beispielsweise angeschlossene Wortleitung WL betrieben wird.

Eine solche Schaltungsanordnung nach dem Stande der Technik, die im allgemeinen in n-Kanal-Technologie aufgebaut ist, weist jedoch einen großen Nachteil auf:

Im Gatebereich des Schalttransistors ST entstehen durch das Hochpumpen auf etwa den doppelten Wert des Versorgungspotentials VDD Spannungswerte, die in der Größenordnung der Durchbruchspannung liegen, die sich aufgrund der bei der Herstellung der Schaltungsanordnung zugrunde gelegten Designregeln zwischen den $n^+$-diffundierten Bereichen von Source und Drain einerseits und dem p-leitenden Substrat andererseits sich ausbildenden Diodenbereiche ergibt (n-Kanal-Technologie angenommen).

Bei der aus der EP-A 0 199 176 bekannten Schaltungsanordnung ist zwischem dem Gate des Schalttransistors ST und dessen Source eine Kapazität vorgesehen. Damit liegt im Betrieb am Dielektrikum der Kapazität eine Potentialdifferenz, die größer als die Versorgungsspannung ist.

Aufgabe der vorliegenden Erfindung ist es, eine möglichst einfache Schaltungsanordnung anzugeben, die das Hochpumpen auf den obengenannten doppelten Wert vermeidet und bei der die vorgenannte Potentialdifferenz höchstens gleich der Versorgungsspannung ist.

Diese Aufgabe wird gelöst bei einer gattungsgemäßen Schaltungsanordnung durch die kennzeichnenden Merkmale des Patentanspruches 1.

Vorteilhafte Aus- und Weiterbildungen sind in Unteransprüchen gekennzeichnet.

Die Erfindung wird im folgenden anhand der Figuren näher erläutert.

Die Figuren 1 bis 3 sind Darstellungen zum Stand der Technik.

Die Figur 4 ist eine vorteilhafte Ausführungsform der Erfindung.

Die Figur 5 zeigt den Spannungsverlauf an markanten Punkten der Schaltungsanordnung.

FIG. 1 als Stand der Technik wurde vorstehend bereits erläutert. Die Miller-Kapazität $C_M$ ist als parasitäre Kapazität gestrichelt gezeichnet.

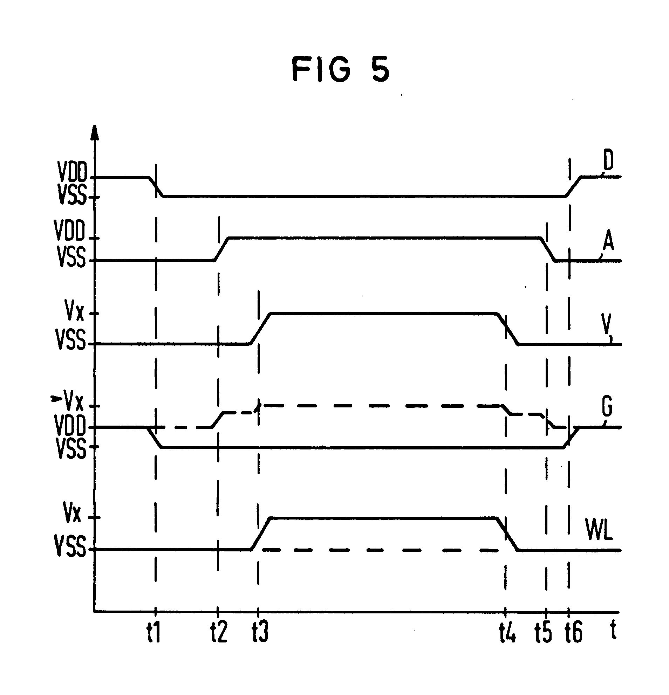

Bei den in den FIG. 2 bis 4 dargestellten Schaltungsanordnungen liegt am Eingang der jeweiligen Schaltungsanordnung ein Eingangssignal D mit negativer Logik an (ausgewählter Zustand = log. 0 = VSS). Anhand von FIG 2 werden nun in Verbindung mit dem Zeitdiagramm nach FIG 5 zwei Fälle beschrieben:

a) Die Wortleitung WL ist ausgewählt (durchgezogene Linie in FIG 5 für Eingangssignal D und Gatespannung G),

b) die Wortleitung WL ist nicht ausgewählt (gestrichelte Linien in FIG 5).

Zu Fall a): Zunächst ist das Eingangssignal D auf log. 1 entsprechend VDD (nicht-ausgewählter Zustand). Da am Gate des Transfertransistors TT die Versorgungsspannung VDD anliegt, hält dieser die Gatespannung G am Gateanschluß des Schalttransistors ST auf log. 1 bzw. in etwa VDD. Zum Zeitpunkt t1 nimmt das Eingangssignal D den Wert log. 0 = beispielsweise VSS an. Der Transfertransistor TT schaltet das Eingangssignal D durch, die Gatespannung G sinkt ebenfalls auf log. 0. Somit schaltet der Schalttransistor ST die beispielsweise von einem Wortleitungsspannungsgenerator gelieferte, getaktete Spannung V, die im Zeitraum von t3 bis t4 gegenüber der Versorgungsspannung VDD den überhöhten Spannungspegel Vx aufweist, auf die Wortleitung WL durch. Die Wortleitung WL nimmt also in etwa den Spannungswert Vx an. Die Gründe für die Verwendung überhöhter Spannungswerte an Wortleitungen wurden bereits dargelegt. Der Schalttransistor ST bleibt durchgeschaltet bis zum Zeitpunkt t6. Zum Zeitpunkt t6 nimmt das Eingangssignal D wieder den Zustand log. 1. an. Somit geht auch die Gatespannung G wieder auf log. 1, was zum Sperren des Schalttransistors ST führt. Die Wortleitung WL behält, beispielsweise durch bekannte, nicht dargestellte Schaltungsmaßnahmen wie einem hochohmigen Widerstand gegenüber VSS, den Wert log. 0 bei. Da der Transfertransistor TT im Zeitraum zwischen t1 und t6 leitet, haben die Miller-Kapazität $C_M$ in FIG 2 bzw. die Kapazität C in den FIG 3 und 4 keinen wesentlichen Einfluß auf das Schaltverhalten der Schaltungsanordnung.

Der Substratbereich des Schalttransistors ST ist als Wanne innerhalb des Substrates der gesamten Schaltungsanordnung ausgebildet, da der Transfertransistor TT und der Schalttransistor ST von zwei verschiedenen, einander entgegengesetzten Leitungstypen sind. Beispielsweise ist der Transfertransistor TT vom n-Kanal-Leitungstyp als erstem Leitungstyp. Entsprechend ist der Schalttransistor ST vom p-Kanal-Leitungstyp als zweitem Leitungstyp. Es sind jedoch auch Schaltungsanordnungen denkbar, in denen der Transfertransistor TT vom p-Kanal-Leitungstyp als erstem Leitungstyp ist. Entsprechend ist dann der Schalttransistor ST vom n-Kanal-Leitungstyp als zweitem Leitungstyp. Im vorliegenden Fall, in dem der Schalttransistor ST vom p-Kanal-Typ sei, ist die Wanne aus n-leitendem Material gebildet. Sie ist mit einer Wannenspannung VW verbunden, die mindestens gleich der überhöhten Spannung Vx ist, die am Schalttransistor ST anliegt. Die Wannenspannung VW kann über einen separaten Spannungsgenerator erzeugt und angelegt werden. Besonders einfach und vorteilhaft ist es jedoch, wie in den FIG 3 und 4 dargestellt, die Wanne W elektrisch mit der getakteten Spannung V zu verbinden.

Zu Fall b): In diesem Fall bleibt das Eingangssignal D konstant auf log. 1. Der Transfertransistor TT hält die Gatespannung G auf log. 1, d.h. in etwa auf Versorgungsspannung VDD. Die getaktete Spannung V nimmt, ebenfalls wie zuvor im Fall a) beschrieben, im Zeitraum zwischen t3 und t4 ihren überhöhten Spannungswert Vx an. Davon wird jedoch die MillerKapazität $C_M$ beeinflußt. Weil der Transfertransistor TT nun sperrt, erfolgt über die Miller-Kapazität $C_M$ ein Hochpumpen ("boosting") der Gatespannung G auf einen gegenüber dem überhöhten Spannungswert Vx nochmals überhöhten Wert. Dieser Zustand dauert von t3 bis t4, d.h. so lange, bis die getaktete Spannung V auf log. 0 (entsprechend ungefähr VSS) zurückgeht. Das Hochpumpen der Gatespannung G ist zwingend erforderlich, weil ansonsten bei Ansteigen der getakteten Spannung V auf Werte oberhalb der Versorgungsspannung VDD + Einsatzspannung Vth des Schalttransistors ST letzterer zunehmend leitend würde und somit die Wortleitung WL fälschlicherweise angewählt würde. Durch das Hochpumpen der Gatespannung G wird dies zuverlässig vermieden.

In der Schaltungsanordnung nach FIG 3 ist die Wirkung der Miller-Kapazität $C_M$ (hier nicht dargestellt) unterstützt durch eine zusätzliche Kapazität C, die zwischen dem Gate des Schalttransistors ST und seiner Source (an der ja die getaktete Spannung V liegt) angeschlossen ist. Als Wannenspannung VW ist die getaktete Spannung V verwendet.

Es kann jedoch auch ein separater Spannungsgenerator dafür verwendet werden wie in FIG 2.

In der erfindungsgemäßen Ausführungsform nach FIG 4 schließlich ist die Kapazität C nicht mit der getakteten Spannung V verbunden (siehe FIG 3), sondern mit einem separaten Taktsignal A mit üblichen logischen Pegeln (siehe FIG 5), d.h. mit logischen Pegeln, die im wesentlichen den Potentialen VDD und VSS entsprechen. Das Taktsignal A bewirkt über die Kapazität C im Zeitraum zwischen t2 und t5 ein erstes Hochpumpen der Gatespannung G über das Versorgungspotential VDD hinaus. Damit ist ein Sperren des Schalttransistors ST sichergestellt. Die bei FIG 2 beschriebene Wirkung des Hochpumpens der Gatespannung G auf den überhöhten Spannungswert tritt auch in der Anordnung nach FIG 4 als zweiter Hochpumpvorgang ein, jedoch erst, wenn die überhöhte Spannung Vx am Schalttransistor ST anliegt (Zeitraum zwischen t3 und t4).

Im ausgewählten Zustand unterscheiden sich die elektrischen Verhältnisse am Gate des Schalttransistors ST bei den Anordnungen nach den FIG 3 und 4 nicht von denen nach FIG 2.

Das Zeitdiagramm nach FIG 5 ist mit Ausnahme des Taktsignales A und des ersten Hochpumpens der Gatespannung G zum Zeitpunkt t2 gültig für alle gezeigten Schaltungsanordnungen. Die Darstellung des Taktsignals A sowie des ersten Hochpumpvorganges trifft nur auf die erfindungsgemäße Anordnung nach FIG 4 zu.

**Patentansprüche**

1.  Schaltungsanordnung in einer integrierten Halbleiterschaltung zum Schalten einer getakteten Spannung (V), die einen gegenüber einer (VDD) von zwei Versorgungsspannungen (VDD, VSS) überhöhten Spannungswert (Vx) aufweist,
    - mit einem Transfertransistor (TT) vom ersten Kanaltyp und einem Schalttransistor (ST) vom zweiten Kanaltyp, dessen Substratbereich als Wanne (W) im Substrat (S) der Schaltungsanordnung ausgebildet ist,
    - die Wanne (W) ist mit einer Wannenspannung (VW) verbunden, die mindestens gleich der zu schaltenden getakteten Spannung ist,
    - das Gate des Schalttransistors (ST) ist mit einer Kapazität (C) verbunden,
    **dadurch gekennzeichnet, daß**
    die Kapazität (C) an ihrem anderen Anschluß mit einem separaten Taktsignal (A), mit den Pegeln der Versorgungsspannungen (VDD, VSS), verbunden ist, so daß die Gatespannung des Schalttransistors (ST) über die eine Versorgungsspannung (VDD) hinaus hochgepumpt wird, und ein Sperren des Schalttransistors (ST) sichergestellt ist, auch wenn der überhöhte Spannungswert (Vx) der getakteten Spannung (V) am Schalttransistor (ST) auftritt.

2.  Schaltungsanordnung nach Anspruch 1, **dadurch gekennzeichnet,** daß der erste Leitungstyp gleich dem n-Kanal-Typ ist.

3.  Schaltungsanordnung nach Anspruch 1, **dadurch gekennzeichnet,** daß der erste Leitungstyp gleich dem p-Kanal-Typ ist.

**Claims**

1.  Circuit arrangement in an integrated semiconductor circuit for switching a pulsed voltage (V) which has a voltage level (Vx) which is raised in comparison with one (VDD) of two supply voltages (VDD, VSS),
    - having a transfer transistor (TT) of the first conductance type and a switching transistor (ST) of the second conductance type, whose substrate region is constructed as a trench (W) in the substrate (S) of the circuit arrangement,
    - the trench (W) is connected to a trench voltage (VW) which is at least equal to the pulsed voltage to be switched,
    - the gate of the switching transistor (ST) is connected to a capacitor (C),
    characterised in that the capacitor (C) is connected at its other terminal to a separate pulsed signal (A) at the levels of the supply voltages (VDD, VSS), such that the gate voltage of the switching transistor (ST) is pumped up above the one supply voltage (VDD), and blocking the switching transistor (ST) is ensured even when the raised voltage level (Vx) of the pulsed voltage (V) occurs on the switching transistor (ST).

2.  Circuit arrangement according to Claim 1, characterised in that the first conductance type is equivalent to the n-conductance type.

3.  Circuit arrangement according to Claim 1, characterised in that the first conductance type is equivalent to the p-conductance type.

**Revendications**

1.  Montage dans un circuit intégré à semiconducteurs pour la commande d'une tension cadencée (V), qui possède une valeur (Vx) accrue par rapport à l'une (VDD) de deux tensions d'alimentation (VDD, VSS), et

- comportant un transistor de transfert (TT) possédant un premier type de canal et un transistor de commutation (ST) possédant un second type de canal, dont la région du substrat est agencée en forme de cuvette (W) dans le substrat (S) du montage,
- la cuvette (W) étant placée à une tension de cuvette (VW) qui est au moins égale à la tension cadencée devant être commandée,
- la grille du transistor de commutation (ST) étant raccordée à une capacité (C);

caractérisé par le fait que la capacité (C) reçoit, au niveau de son autre borne, un signal de cadence séparé (A) possédant les niveaux des tensions d'alimentation (VDD et VSS) de sorte que la tension de grille du transistor de commutation (ST) est amenée à un niveau élevé dépassant une tension d'alimentation (VDD), et qu un blocage du transistor de commutation (ST) est garanti même lorsque la valeur accrue de tension (Vx) de la tension cadencée (V) apparaît dans le transistor de commutation (ST).

2. Montage suivant la revendication 1, caractérisé par le fait que le premier type de conduction est le type à canal n.

3. Montage suivant la revendication 1, caractérisé par el fait que le premier type de conduction est le type à canal p.

FIG 1

FIG 2

FIG 3

FIG 4

# FIG 5